Europäisches Patentamt

European Patent Office

Office européen des brevets

(11) Publication number: **0 412 837 A2**

# EUROPEAN PATENT APPLICATION

(21) Application number: 90308819.3

(51) Int. Cl.⁵: **G11C 16/06**

(22) Date of filing: **10.08.90**

(30) Priority: **11.08.89 JP 208703/89**

(43) Date of publication of application:
**13.02.91 Bulletin 91/07**

(84) Designated Contracting States:
**DE FR GB**

(71) Applicant: **SONY CORPORATION**
**7-35 Kitashinagawa 6-Chome Shinagawa-ku**
**Tokyo 141(JP)**

(72) Inventor: **Arakawa, Hideki, c/o Patents Divison**
**Sony Corporation, 6-7 35 Kitashinagawa**
**Shinagawa-ku, Tokyo 141(JP)**

(74) Representative: **Thomas, Christopher Hugo et**
**al**
**D Young & Co 10 Staple Inn**
**London WC1V 7RD(GB)**

(54) **Ultraviolet erasable non-volatile memory devices.**

(57) An ultraviolet erasable non-volatile memory device comprises a plurality of memory cells (10) which are erasable by ultraviolet rays and employs a sensing amplifier including a current mirror circuit (14, 15) connected to the memory cells (10) and a reference cell (11) respectively for read-out. In one example, an effective control gate voltage of the reference cell (11) is set to a lower value than that of the memory cells (10. The current drivability of the reference cell exhibits an intermediate value between that of an erased memory cell (10 and that of a programmed memory cell (10). In another example, a constant current source (32) is provided at a node (36) between the memory cells (10) and the current mirror circuit (14, 15), so that a current on the reference cell side is subtracted by the constant current source (32).

**FIG.3**

## ULTRAVIOLET ERASABLE NON-VOLATILE MEMORY DEVICES

This invention relates to ultraviolet erasable non-volatile memory devices.

Non-volatile memory devices can erase, by irradiation of ultraviolet rays or electrically, information stored in memory cells.

To read out information stored in such memory cells, sensing amplifiers are generally used. Various sensing amplifiers are known, such as for example, a sensing amplifier to sense the potential on a bit line, the potential being amplified by an inverter to read it out, and a sensing amplifier to supply a potential on a bit line of a reference cell and a potential on a bit line of the memory cell to a differential amplifier to provide an output by comparison between the potentials. In addition, a sensing amplifier using a current mirror circuit has been disclosed in 1989, IEEE, ISSCC (International Solid-State Circuits Conference), Digest of Technical Papers, pages 138 and 139, NON-VOLATILE MEMORIES/ A 1Mb FLASH EEPROM.

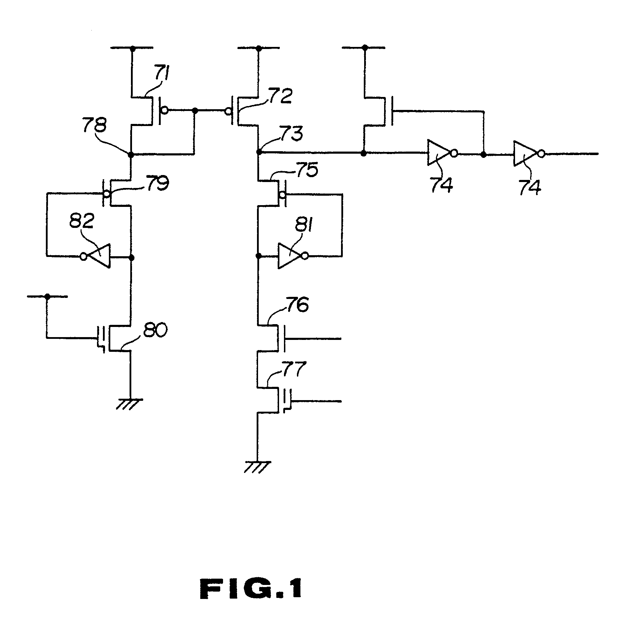

Figure 1 shows such a sensing amplifier using a current mirror circuit. The current mirror circuit comprises a pair of pMOS transistors 71 and 72. A power supply voltage Vcc is supplied to each source. The drain 78 of the pMOS transistor 71 is commonly connected to respective gates of the pMOS transistor 71 and 72. The drain of the pMOS transistor 72 serves as a sensing node 73. A potential on the node 73 is amplified by inverters 74 and 74, to provide an output. A memory cell 77 in which information is stored is connected to the sensing node 73 through an nMOS transistor 75 having a low threshold voltage Vth functioning as a limiter by an inverter 81 and a column select transistor 76. The drain 78 of the transistor 71 is connected to a reference cell 80 through an nMOS transistor 79 having a low threshold voltage Vth functioning as a limiter by an invertor 82 in a manner similar to the above. The memory cell 77 and the reference cell 80 are structures comprising a floating gate and a control gate stacked through insulating film. The power supply voltage Vcc is supplied to the control gate of the reference cell. The control gate of the memory cell 77 serves as a word line.

In the sensing amplifier having such a structure, the potential on the sensing node 73 rises and falls in dependence upon the difference between the current drivability of the reference cell 80 and the current drivability of the memory cell 77. A potential difference thus obtained is amplified and is read out.

However, such a sensing amplifier comprising a current mirror circuit is operative because the memory cell 77 is of an electrically erasable type, and it cannot be applied to a non-volatile memory device for erasing information in memory cells by ultraviolet rays.

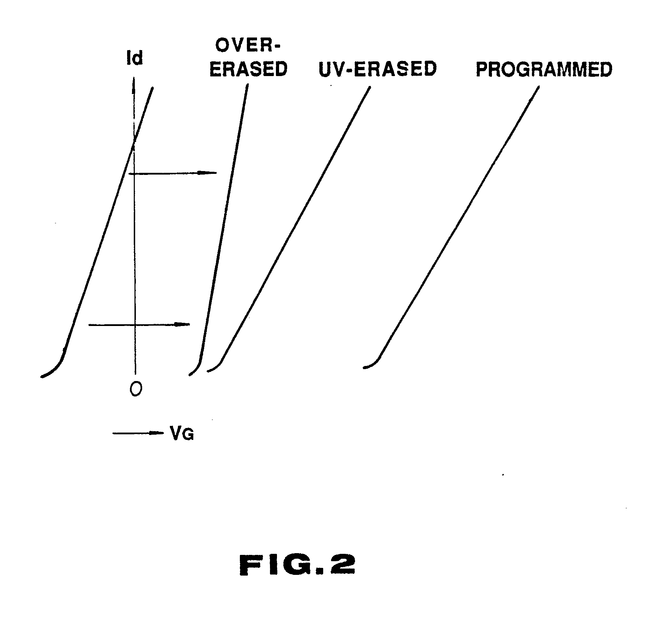

In the non-volatile memory device of Figure 1, the reference cell 80 is erased by ultraviolet rays, but the memory cell 77 is electrically erased. As a result, there is a tendency for the floating gate to be positively charged by an electrical erase operation (over-erase operation) of the memory cell 77. Thus, as shown in Figure 2, the current characteristic of a ultraviolet-ray erased cell of the reference cell becomes equal to an intermediate characteristic between the current characteristic of a programme cell and the current characteristic of a programmed cell and the current characteristic of an over-erased memory cell. As a result, there occurs a difference between a potential when the memory cell 77 is erased and a potential when it undergoes a write operation, and such a potential difference is read out. In Figure 2, the ordinate and the abscissa represent a current and a control gate voltage, respectively.

However, in a non-volatile memory device which is not electrically erasable, but is erasable by ultraviolet rays, the current characteristic of an erased memory cell corresponds to the current characteristic based on erasing by ultraviolet rays of the reference cell. For this reason, the sensing amplifier might in an extreme case erroneously judge the memory cell to be in a written state when in fact it is erased due, for example, to tolerances (inconsistency) in production.

To avoid such erroneous operation, there has been proposed a method of holding down the channel width of the pMOS transistor 72 forming the current mirror circuit of Figure 1 to one half that of the transistor 71. However, this method presents a current characteristic different from the current characteristic of the cell. As a result, the sensitivity in a read-out operation varies substantially in dependence upon a write level.

According to the present invention there is provided an ultraviolet erasable non-volatile memory device comprising:

a plurality of memory cells for storing information, said memory cells being erasable by ultraviolet rays;

a reference cell having the same structure as said memory cells, said reference cell, being erasable by ultraviolet rays;

a sensing amplifier having a current mirror circuit, one node of said current mirror circuit being connected to said memory cells, the other node of said current mirror circuit being connected to said reference cell;

means for selecting said memory cells by a signal which has a predetermined voltage; and

means for driving said reference cell by a signal, said signal having a voltage lower than said predetermined voltage.

According to the present invention there is also provided an ultraviolet erasable non-volatile memory device comprising:

a plurality of memory cells for storing information, said memory cells being erasable by ultraviolet rays;

a reference cell having the same structure as said memory cells, said reference cell being erasable by ultraviolet rays;

a sensing amplifier having a current mirror circuit, one node of said current mirror circuit being connected to said memory cells, the other node of said current mirror circuit being connected to said reference cell;

a constant current source connected to a node between said memory cells and said current mirror circuit.

In one embodiment of the invention, an ultraviolet erasable non-volatile memory device includes a sensing amplifier in which a reference cell and memory cells are respectively connected to a current mirror circuit to amplify the potential on a node on the memory cell side to read out the data.

The control gate of the reference cell may be supplied with a lower effective voltage than a predetermined voltage which is supplied to the memory cells. In this embodiment. an intermediate current drivability between the current drivability in a state erased by ultraviolet rays and the current drivability in a programmed state is obtained in the reference cell.

In another embodiment of the invention, a sensing amplifier using a current mirror circuit to which a reference cell and a memory cell are respectively connected amplify a potential on a node of the memory cell side. A constant current source is connected to the node, so a current on the memory cell side which originally reflects a current on the reference cell side by the current mirror circuit has subtracted from it a fixed current.

The invention will now be described by way of example with reference to the accompanying drawings, throughout which like parts are referred to by like references, and in which:

Figure 1 is a circuit diagram of a known nonvolatile memory device;

Figure 2 is a diagram showing current characteristics;

Figures 3, 4 and 6 are circuit diagrams showing the circuit configuration of respective embodiments of ultraviolet-ray erasable non-volatile memory device according to this invention; and

Figure 5 is a diagram showing current characteristics.

The first embodiment is an example of an EPROM having a sensing amplifier in which the control gate voltage of the reference cell is lowered.

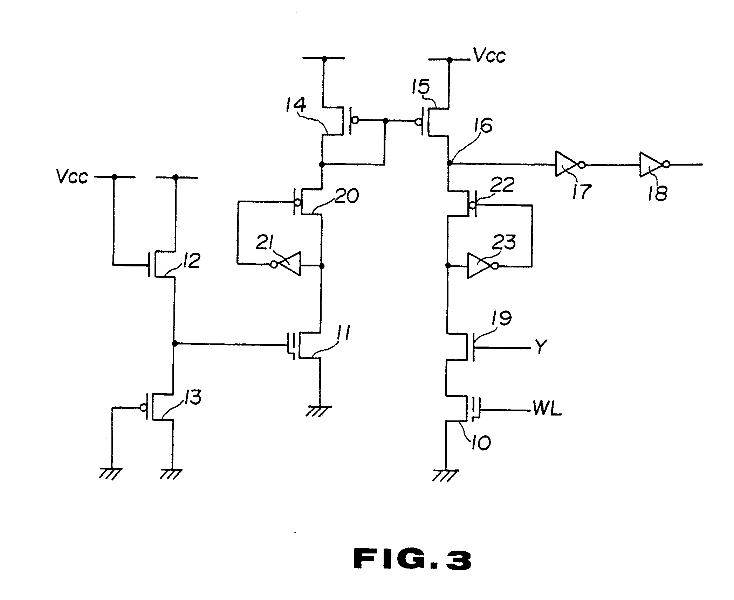

Its circuit configuration comprises, as shown in Figure 3, a current mirror circuit comprising a pair of pMOS transistors 14 and 15. A power supply voltage Vcc is supplied to each of the sources of the transistors 14 and 15. Respective gates of the transistors 14 and 15 are commonly connected, and the junction thereof is connected to the drain of the transistor 14.

The drain of the transistor 15 serves as a sensing node 16. By amplifying a potential on the sensing node 16, read-out operation is carried out. Inverters 17 and 18 connected in series are connected to the sensing node 16. Amplification of a voltage is carried out by the inverters 17 and 18.

One of the source and the drain of an nMOS transistor 22 having a low threshold voltage functioning as a limiter is connected to the sensing node 16. The other of the source and the drain of the nMOS transistor 22 is connected to a bit line. A voltage on the bit line is inverted by an inverter 23 and the inverted voltage is supplied to the gate of the nMOS transistor 22.

One of the source and the drain of a memory cell 10 is connected to the bit line through a column select transistor 19 selected by a column select line Y. Earth potential GND is connected to the other of the source and the drain. Although not shown, a plurality of memory cells 10 are arranged in a matrix manner, and column select transistors 19 are also arranged in correspondence with the number of columns. Each memory cell 10 is of a structure comprising a floating gate and a control gate stacked through insulating films. The control gate is connected to the word line WL for selection of the row. The word line WL is supplied with predetermined voltages at the selecting time by a row decoder. The memory cell 10 is such that information can be written there into by injecting electrons into the floating gate, and erased therefrom by ultraviolet rays.

The drain of the transistor 14 is connected to one of the source and the drain of an nMOS transistor 20 having a low threshold voltage. The other of the source and the drain of the transistor 20 is connected to a reference cell 11. The output terminal of an inverter 21 is connected to the gate of the transistor 20, and the input terminal of the inverter 21 is connected to the other of the source and the drain of the transistor 20. The transistor 20 and the inverter 21 operate in a manner similar to the transistor 22 and the inverter 23.

The reference cell 11 is an element having a current drivability transmitted to the sensing node 16 by the current mirror circuit, and includes a floating gate and a control gate stacked through insulating films. The reference cell 11 is made similarly to the memory 10. Accordingly, even in the case where there occur tolerances in the process, the reference cell 11 and the memory cell 10 have the same tendency. The earth potential GND is connected to the source/drain on the side opposite to the side connected to the nMOS transistor of the reference cell 11. A voltage which is lower than the power supply voltage Vcc by the threshold voltage Vth through an nMOS transistor 12 is supplied to the control gate of the reference cell 11. Thus the nMOS transistor 12 and pMOS transistor 13 are connected in series between the power supply voltage Vcc and the earth potential GND. The drain/gate of the transistor 12 are maintained at the power supply voltage Vcc, and the drain/gate of the transistor 13 are maintained at the earth potential GND. The transistors 12 and 13 are in a diode connection state, and the potential on the source is set to Vcc-Vth. This voltage is supplied to the control gate of the reference cell 11. Assuming now that the power supply voltage Vcc is equal to about 5 volts, because the threshold voltage Vth is about 1 volt, a voltage supplied to the gate of the reference cell 11 becomes equal to about 4 volts.

The EPROM having such a circuit configuration operates as follows.

Because the reference cell 11 has undergone erase operation by ultraviolet rays, the current drivability of the reference cell 11 becomes large. However, a voltage supplied to the control gate of the reference cell 11 is lowered by the threshold voltage Vth by the nMOS transistor 12, etc. As a result, the current drivability of the reference cell 11 is reduced accordingly. A current flowing in the reference cell 11 flows into the pMOS transistor 14 forming the current mirror circuit. Thus, a current flowing in the transistor 15 depends upon the current drivability of the reference cell 11. As stated above, a current flowing in the transistor 15 flows into the sensing node 16 which depending upon the current drivability of the reference cell 11 reduced by the threshold voltage Vth thereof. The memory cell 10 is connected to the sensing node 16 through the column select transistor 19, etc. In the case where the memory cell 10 is in a written state, because the current drivability of the memory cell 10 is low, a potential on the sensing node 16 is placed at a high value. On the other hand, in the case where the memory cell 10 is placed in an erased state by ultraviolet rays, the current drivability of the memory cell 10 becomes high, but because a current flowing in the transistor 15 reflecting the reference cell 11 is suppressed by a drop of the threshold voltage Vth, there occurs a difference corresponding to that voltage drop, with the result that a potential on the sensing node 16 is placed at a lower value. Accordingly, whether information is written into the memory cell 10 or is erased therefrom may be sensed.

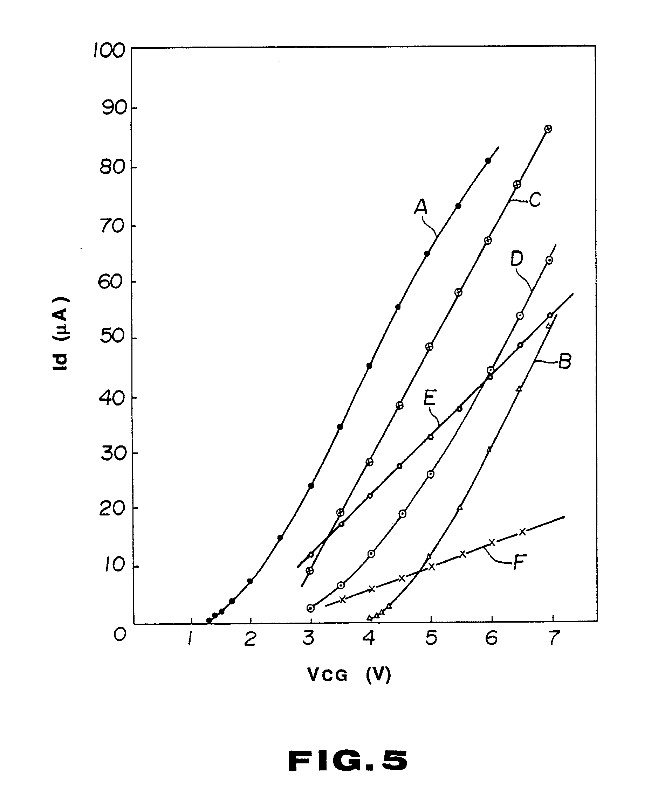

Since the reference cell 11 is formed by the same process as that of the memory cell 10 in such an EPROM, even in the case where the characteristic of the memory cell 10 varies, the reference cell 11 also varies with the same tendency as that of the memory cell 10. Thus, sensing is not effected. Moreover, when a write level changes, generally the operating point changes. However, as described later with reference to Figure 5, since the reference cell 11 has the same characteristic curve as that of the memory cell 10, a stable read-out operation can be achieved regardless of the presence and absence of a write operation.

In addition, by providing the means for somewhat lowering the control voltage at the time of a verify operation, or for increasing to a current caused to flow from the sensing node 16, it is possible to make an additional write pulse unnecessary.

An EPROM forming the second embodiment is characterized in that a constant current source is provided at the sensing node.

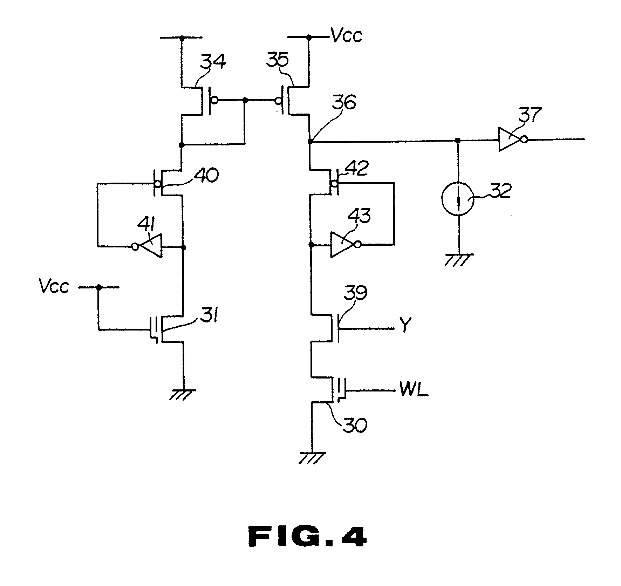

Its circuit configuration includes, as shown in Figure 4, a current mirror circuit comprising a pair of pMOS transistors 34 and 35. A power supply voltage Vcc is supplied to each source of the transistors 34 and 35. The gates of the transistors 34 and 35 are commonly connected to the drain of the transistor 34.

The drain of the transistor 35 serves as a sensing node 36. By amplifying a potential on the sensing node 36, a read-out operation is carried out. An inverter 37 is connected to the sensing node 36. By the inverter 37, amplification of a voltage is carried out. In this embodiment, a constant current 32 is further connected to the sensing node 36. An earth potential GND is supplied to abode on the opposite side of the sensing node 36 of the constant current source 32. The constant current source 32 serves to allow a current flowing in the transistor 35 through a path different from that of the memory cell 30, and seemingly functions to lower the current drivability of the reference cell 31.

One of the source and the drain of an nMOS transistor 42 having a low threshold voltage functioning as a limiter is connected to the sensing node 36 in the same manner as in the EPROM of the first embodiment. The other of the source and the drain of the transistor 42 is connected to a bit line. A voltage on the bit line is inverter by an inverter 43 and the inverted voltage is supplied to the gate of the transistor 42.

One of the source and the drain of a memory cell 30 is connected to the bit line through a column select transistor 39 selected by a column select line Y. The earth voltage GND is connected to the other of the source and the drain thereof. Although not shown, a plurality of memory cells 30 are arranged in a matrix manner, and column select transistors 39 are arranged in correspondence with the number of columns. Each memory cell 30 is of a structure comprising a floating gate and a control gate stacked through insulating films, respectively. The control gate is connected to a word line WL for selection of the row. The memory cell 30 is such that information can be written by injecting electrons into the floating gate, and erased therefrom by ultraviolet rays.

The drain of the transistor 34 is connected to one of the source and the drain of an nMOS transistor 40 having a low threshold voltage, and the other of the source and the drain of the transistor 40 is connected to a reference cell 31. The output terminal of an inverter 41 is connected to the gate of the transistor 40, and the input terminal of the inverter 41 is connected to the other of the source and the drain of the transistor 40.

The reference cell 31 is an element having a current drivability transmitted to the sensing node 36 by the current mirror circuit, and includes a floating gate and a control gate stacked through insulating films. The reference cell 31 is formed by the same process as that of the memory cell 30. Accordingly, even in the case where there occur tolerances in the process, the reference cell 31 and the memory cell 30 will have the same tendency. The earth voltage GND is supplied to the source and the drain on the side opposite to the side connected to the nMOS transistor of the reference cell 31. Moreover, the power supply voltage Vcc is supplied to the control gate of the reference cell 31.

The EPROM of this embodiment having such a circuit configuration has a high current drivability because the reference cell 31 is subjected to an erase operation by ultraviolet rays. However, since a current in the pMOS transistor 35 of the current mirror circuit is subtracted by the constant current source 32, the current drivability of the reference cell 31 seemingly becomes equal to an intermediate value between the current drivability at the time of a write operation of the memory cell and that at the time of an erase operation thereof.

Namely, a current flowing in the reference cell 31 becomes equal to a current flowing in the pMOS transistor 34. The current drivability of the current mirror connected transistor 35 also becomes equal to a value reflecting the current drivability of the reference cell 31. However, since the constant current source 32 is connected to the sensing node 36 connected to the transistor 35, a current flowing on the memory cell 30 side becomes equal to a portion of a current which has been passed through the transistor 35. For this reason, the current drivability of the transistor 35 becomes equal to an intermediate value between the current drivability of the memory cell 30 at the time of a write operation thereof and that at an erase operation thereof. Accordingly, at the time of a write operation, the potential on the sensing node 36 rises, and at the time of an erase operation, the potential on the sensing node 36 falls. A reliable read-out operation is thus carried out.

Since the reference cell 31 is formed by the same process as that of the memory cell 30 in such an EPROM, changes in the characteristics of the cells 30 and 31 have the same tendency. As a result, sensing is not affected by the influence of tolerances. Moreover, even when a write level varies, as described later with reference to Figure 5, the reference cell 31 has the same characteristic curve as that of the memory cell 30. Thus, a stable read-out operation can be made. In addition, also at the time of a verify operation, it is possible to make an additional write pulse unnecessary.

The EPROM which has been described in the first and second embodiments will now be described in more detail with reference to Figure 5, while making a comparison with a reference example.

Figure 5 is a diagram in which the abscissa and the ordinate are taken as a control gate voltage and a drain current, respectively. The curve A represents the current drivabilities of the memory cell and the reference cell in the case where erasing is effected by ultraviolet rays. In the case where the reference cell and the memory cell are both of ultraviolet-ray erasable type, they exhibit the same curve. As a result, it is difficult to use the reference cell for reference. On the other hand, the curve B is a curve in the case where writing is effected into the memory cell. As compared with the erased case (curve A), a current value at the same control gate voltage becomes small. As stated above, the current drivability of the memory cell is represented as the curve B in the written case and is represented as the curve A in the erased case.

The curve F represents an element characteristic of the reference example No. 1. Although not shown, no reference cell is used and a load connected to the sensing node is fixed to a pMOS transistor (W/L = 4/40). This curve F represents a substantially linear current characteristic which rises at a low rate. Judgment can be made because the curve F is located between curves A and B in the vicinity of 4 volts, but its current value is low, so employment of the curve F is not practical.

The curve E represents an element characteristic of the reference example No. 2. In the circuit of Figure 1, the channel width of the pMOS transistor 72 is set to a value one half of the channel width of the pMOS transistor 71. In the case of this curve E, the current drivability of the transistor 72 rises at a rate higher than that of the curve F and becomes close to the current drivabilities (curves A and B) of the memory cell, but the gradient of rise is not parallel to those of the curves A and B. Accordingly, in dependence upon changes in the control gate voltage or the write level, the operating point of sensing would vary. As a result, a stable read-out operation cannot be carried out.

The curve C represents a characteristic curve of the second embodiment. A current flowing in the transistor 34 seemingly shifts to the side where a current value is reduced with an offset corresponding to a current subtracted by the constant current source 32 from the curve A of the reference cell. For this reason, the curve C has an intermediate characteristic between the characteristics of the curves A and B, and the gradient of the characteristic curve has a tendency along those of the curves A and B. Accordingly, even in the case where the control gate voltage or the write level, etc. vary, the relative positional relationship between curves A and B and the curve C is unchanged. Thus, a stable read-out operation is realized.

The curve D is a characteristic curve relating to the EPROM of the first embodiment. Also in the case of this curve D, in the same manner as in the curve C, the current drivability is reduced to such an extent that a dropped control gate voltage is supplied to the reference cell. The gradient of this curve D has a tendency along the tendencies of the gradients of the curves A and B. For this reason, in the same manner as in the curve C, the relative positional relationship between the curves A and B and the curve D is unchanged. Thus, a stable read-out operation is realized.

As stated above, unlike the reference examples (curves E and F), EPROMs (curves D and C) of the first and second embodiments have a tendency similar to that of the memory cells (curves A and B), and taken an intermediate value. For this reason and because of the fact that the reference cell is formed by the same process, a stable readout operation is realized.

An EPROM of the third embodiment is a modified example of the EPROM of the second embodiment. This embodiment includes switch means for short-circuiting the input and output terminals of an inverter for an output.

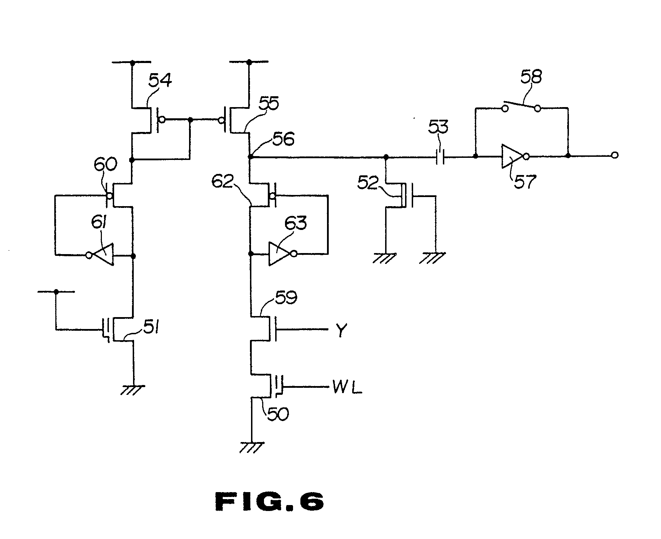

Its circuit configuration includes, as shown in Figure 6, a current mirror circuit comprising a pair of a MOS transistors 54 and 55. A power supply voltage Vcc is supplied to each of the sources of the transistors 54 and 55. The gates of the transistors 54 and 55 are connected commonly to the drain of the transistor 54.

The drain of the transistor 55 serves as a sensing node 56. By amplifying a potential on the sensing node 56, a read-out operation is carried out. An inverter 57 is connected to the sensing node 56 through a capacitor 53. By this inverter 57, amplification of a voltage is carried out. Between the input terminal and the output terminal of the inverter 57, there is provided switch means 58 for short-circuiting these terminals. Before read-out operation, the switch means 58 is turned ON, so the input and output terminals of the inverter 57 are short-circuited. Thus, these input and output terminals are precharged so that the input and output levels become equal to 1/2 Vcc. At the time of a read-out operation, the switch means 58 is turned OFF. By the operation of the switch means 58, it is possible to shorten a transition time in the case of reading out data inverted with respect to preceding data.

In the EPROM of this embodiment, in the same manner as the EPROM of the second embodiment, a depletion type MOS transistor 52 functioning as a constant current source is connected to the sensing node 56. An earth potential GND is connected to the node on the opposite side of the sensing node 56 of the MOS transistor 52. The transistor 52 seemingly functions to lower the current drivability of the reference cell 51.

To the sensing node 56 and the drain of the transistor 54, nMOS transistors 62 and 60 each having a low threshold voltage functioning as a limiter are connected in the same manner as in the EPROM of the second embodiment, respectively. To the gates thereof, voltages obtained by inverting drain voltages are supplied by inverters 63 and 61, respectively.

Moreover, one of the source and the drain of a memory cell 50 is connected to the bit line through a column select transistor 59 in the same manner as in the second embodiment. A plurality of memory cells 50 are arranged in a matrix manner. Each memory cell 50 has a structure comprising a floating gate and a control gate stacked through insulating films. The control gate thereof is connected to the word line WL for selection of rows. The memory cell 50 is such that information can be written thereinto by injecting electrons into the floating gate, and erased by ultraviolet rays.

A reference cell 51 connected to the drain of the transistor 60 is an element having a current drivability transmitted to the sensing node 56 by the current mirror circuit. The reference cell 51 includes a floating gate and a control gate formed by the same process as that of the memory cell 50. Accordingly, even in the case where there occur tolerances in the process, the reference cell 51 and the memory cell 50 have the same tendency. The earth potential CND is connected to the source and the drain on the side opposite to the side connected to the nMOS transistor of the reference cell 51, and the power supply voltage Vcc is supplied to the control gate thereof.

The EPROM of this embodiment having such a circuit configuration is caused to have a high current drivability because the reference cell 51 undergoes erasing by ultraviolet rays in the same manner as in the memory cell 50. However, since a current in the transistor 55 of the current mirror circuit is subtracted by the depletion type MOS transistor 52 functioning as a constant current course, the current drivability of the reference cell 51 is allowed to be seemingly an intermediate value between the current drivability at the time of a write operation and that at the time of an erase operation (see the curve C in Figure 5). Accordingly, in the same manner as in the second embodiment, a potential on the sensing node 56 rises at the time of a write operation and a potential on the sensing node 56 falls at the time of an erase operation. Thus, a reliable read-out operation is carried out.

Especially in the case of the EPROM of this embodiment, since the inverter 57 includes switch means 58 for short-circuiting the input and output terminals before a read-out operation to precharge them, a stable read-out operation and a high speed potential detection can be made.

## Claims

1. An ultraviolet erasable non-volatile memory device comprising:
a plurality of memory cells (10) for storing information, said memory cells (10) being erasable by ultraviolet rays;
a reference cell (11) having the same structure as said memory cells (10), said reference cell (11), being erasable by ultraviolet rays;
a sensing amplifier having a current mirror circuit (14, 15), one node (16) of said current mirror circuit (14, 15) being connected to said memory cells (10), the other node of said current mirror circuit (14, 15) being connected to said reference cell (11);
means (19) for selecting said memory cells (10) by a signal which has a predetermined voltage; and
means (12, 13) for driving said reference cell (11) by a signal, said signal having a voltage lower than said predetermined voltage.
2. A device according to claim 1 wherein said memory cells (10) and said reference cell (11) have a field effect transistor structure comprising a floating gate and a control gate stacked through insulating films, and said signals provided by said means (19) for selecting and said means (12, 13) for driving are supplied to said control gates.
3. A device according to claim 2 wherein said memory cells (10) are arranged in a two-dimensional matrix array of rows and columns, and said means (19) for selecting is a row decoder.
4. A device according to claim 1, claim 2 or claim 3 wherein said means (12, 13) for driving comprises an nMOS transistor (12) and a pMOS transistor (13), a drain and a gate of said nMOS transistor (12) being supplied with a power supply voltage, and a drain and a gate of said pMOS transistor (13) being supplied with earth potential, the sources of said nMOS transistor (12) and said pMOS transistor (13) being connected to said reference cell (11) in common.
5. An ultraviolet erasable non-volatile memory device comprising:
a plurality of memory cells (30) for storing information, said memory cells (30) being erasable by ultraviolet rays;
a reference cell (31) having the same structure as said memory cells (30), said reference cell (31) being erasable by ultraviolet rays;
a sensing amplifier having a current mirror circuit (34, 35), one node (36) of said current mirror circuit (34, 35) being connected to said memory cells (30), the other node of said current mirror circuit (34, 35) being connected to said reference cell (31);
a constant current source (32) connected to a node (36) between said memory cells (30) and said current mirror circuit (34, 35).
6. A device according to claim 5 wherein said constant current source (52) is a depletion type MOS transistor (52).
7. A device according to claim 5 wherein an inverter (57) connected to said node (56) amplifies the potential at said node (56), and a input terminal and a output terminal of said inverter (57) are connected each other by a switching means (58) before a data outputting operation.

**FIG.1**

**FIG.2**

**FIG.3**

**FIG. 4**

**FIG. 5**

FIG.6